Europäisches Patentamt

European Patent Office

Office européen des brevets

(11) Publication number: **0 132 954**
**A2**

(12) **EUROPEAN PATENT APPLICATION**

(21) Application number: **84304408.2**

(22) Date of filing: **28.06.84**

(51) Int. Cl.⁴: **C 30 B 29/10**
**C 30 B 11/02**

(30) Priority: **29.06.83 US 509158**

(43) Date of publication of application:
**13.02.85 Bulletin 85/7**

(84) Designated Contracting States:
**AT BE CH DE FR GB IT LI LU NL SE**

(71) Applicant: **STAUFFER CHEMICAL COMPANY**

**Westport Connecticut 06881(US)**

(72) Inventor: **Baumann, John Andrew**
**112 Pine Avenue**
**Ossining New York 10562(US)**

(72) Inventor: **Marek, Henry Samuel**
**RR No. 3 Salem Lane**
**South Salem New York 10590(US)**

(72) Inventor: **Michel, Christian Gabriel**
**15 Edgewood Road**
**Ossining New York 10562(US)**

(74) Representative: **Smith, Sydney et al,**
**Elkington and Fife High Holborn House 52/54 High**
**Holborn**
**London WC1V 6SH(GB)**

(54) **Liquid phase growth of crystalline polyphosphide.**

(57) A process for the production of polyphosphide crystals characterised in that it comprises liquid phase growth of polyphosphide crystals from a polyphosphide melt.

More particularly, the process may comprise

(A) heating a polyphosphide charge to a melt having a temperature substantially within the range of from 650 to 670°.C; and

(B) slowly cooling the melt to form polyphosphide crystals.

Referring to the accompanying illustrative diagram, the present process may be applied to the growth of crystals of melt 22 on substrates 24 by tilting a sealed ampule 20.

The present invention represents an advance over the prior art.

FIG. I

## Liquid phase growth of crystalline polyphosphide

This invention relates to the liquid phase growth of crystalline polyphosphide; more particularly, it relates to the growth of large crystals of $KP_{15}$ for use in related processes, to the application of phosphorus layers to silicon and silicon integrated circuit devices and to the application of phosphorus layers as the insulating layer in MIS devices on III-V semiconductors.

The large crystals of polyphosphides formed by the present process may also be used in electro-optical devices and as optical rotators.

For further information, reference may be made to, for example, GB-A- 2,113,663 and to the related applications filed herewith, in particular those based on USSN 509,175, USSN 509,157, USSN 581,115 and USSN 581,139.

The related applications disclose semiconductors formed of catenated phosphorus materials. It is highly desirable that large crystals of these materials be formed for use in electronic and electro-optical devices and as optical rotators. It is also highly desirable that such materials be grown on III-V semiconductors, such as gallium arsenide and gallium phosphide, to form the I-layer thereof in MIS devices as disclosed in the above-mentioned related applications, in particular that based on USSN 581,115.

It is therefore an object of the present invention to provide polyphosphide materials.

Another object of the present invention is to provide polyphosphide materials by liquid phase growth.

A further object of the present invention is to provide polyphosphide films by liquid phase growth on a variety of substrates.

A still further object of the present invention is to provide large crystals of polyphosphides.

Yet another object of the present invention is to

0132954

provide semiconductor and electro-optical devices, optical film coatings and optical rotators.

The present invention provides a process for the production of polyphosphide crystals characterised in that it comprises liquid phase growth of polyphosphide crystals from a polyphosphide melt.

More particularly, the present process may comprise:

(A) heating a polyphosphide charge to a melt having a temperature substantially within the range of from 650 to 670°C; and

(B) slowly cooling the melt to form polyphosphide crystals.

optionally further

(C) bringing the melt into contact with a substrate to form crystals on the substrate during the slow cooling step;

optionally further

(D) removing the melt from the substrate at the termination of the slow cooling step;

optionally further

(E) terminating the slow cooling step when the melt reaches a temperature substantially in the range of from 630 to 640°C.

The preferred polyphosphide is $KP_{15}$.

In one preferred embodiment, the charge is contained in a sealed, preferably evacuated ampule, before heating. When crystals are to be grown on a substrate, this may be accomplished by tilting the ampule to bring the melt into contact therewith. Preferred substrates include quartz, nickel and III-V semiconductors, such as gallium arsenide and gallium phosphide. The melt is preferably cooled slowly, for example at a rate of from 6 to 60C° per hour. It may comprise a metal dopant, such as nickel.

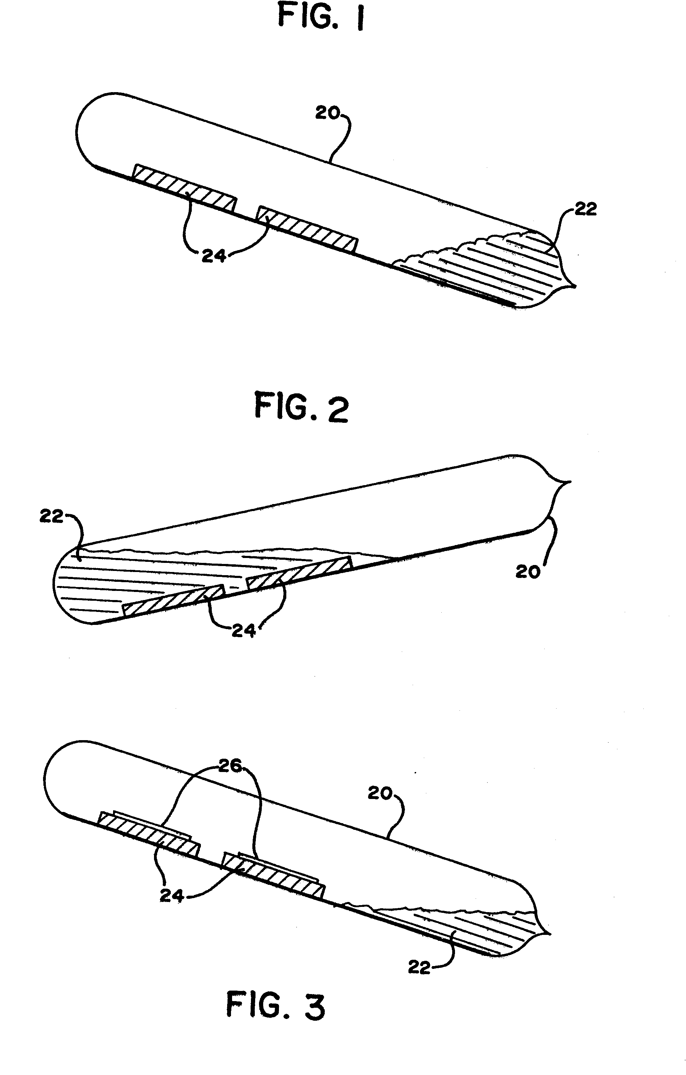

For a fuller understanding of the nature and objects of the present invention reference may be made to the accompanying illustrative drawing wherein Figures 1, 2

and 3 are schematic diagrams illustrating how a heated ampule is utilized in carrying out the present invention.

For purposes of illustration, quartz tubes of 10mm outside diameter and 6mm inside diameter or 11mm outstide diameter and 9mm inside diameter are loaded with from 0.5 to 2.0 grams of $KP_{15}$ material produced by the condensed phase process of the above-identified, related applications. The ampules are pumped down to $10^{-4}$ Torr ($1.33 \times 10^{-2}$ Pa) and sealed    under vacuum.

Referring to accompanying Figure 1, a sealed quartz ampule 20 contains a charge of condensed phase $KP_{15}$ 22 and substrates 24. The ampule 20 is mounted in a furnace, tilted as shown and heated to 655°C in order to melt the $KP_{15}$ charge 22. The ampule is then tilted as shown in accompanying Figure 2 so that the melt 22 is in contact with the substrates 24. This may be accomplished by tilting the entire furnace including the ampule. The ampule 20 is then allowed to cool slowly at a rate of from 6 to 60C° per hour to 640°C and then the ampule 20 is tilted to its original position as shown in accompanying Figure 3 and rapidly cooled to room temperature. Polycrystalline films 26 form on the substrates 24 during the slow cooling.

Polished wafers of gallium arsenide cleaved along the 110 face and gallium phosphide cleaved along the 111 face, silicon cleaved along the 110 face, a 2000 angstroms ($2 \times 10^{-7}$ m) evaporated nickel layer on quartz, quartz and nickel foil have been utilized as substrates. In all cases, massive crystallization of $KP_{15}$ whiskers and platelets directly from the melt has been observed. Polycrystalline $KP_{15}$ films were grown on all of the substrates. Crystalline $KP_{15}$ platelets 3 x 3mm in size have been obtained by cleaving grown film from gallium phosphide substrates. Two-dimensional growth of $KP_{15}$ film on the P face of gallium phosphide is observed. The surface morphology of the grown layer suggests topotaxial growth and provides the basis for the application of $KP_{15}$, thin films as the insulating layer for gallium arsenide, gallium phosphide and indium phosphide MIS devices.

By incorporating nickel foil or nickel powder from 1 to 5%, by weight, in the melt and raising the melt to a temperature of 670°C and then slowly cooling to 630°C while in contact with substrates _in situ_ doping of $KP_{15}$ with nickel has been produced.

Other alkali metal polyphosphides of the formula: $MP_{15}$, wherein M represents an alkali metal, may also be grown from the liquid melt.

It has been found that the ampules should first be heated to from 650 to 670°C in order to melt the charge. When nickel dopant is included in the charge, temperatures in the higher portion of the range are preferred. The slow cooling when the melt is in contact with the substrates may as previously stated vary from 6 to 60C° per hour. The final cooling temperature while the melt is still in contact with the substrates may vary from 640 to 645°C.

In all cases, large quantities of polycrystalline whiskers and platelets are formed directly from the melt, as well as on the substrates. Thus, the process is a convenient technique to produce large quantities of high quality $KP_{15}$ polycrystalline bulk material in a relatively short time (a few hours) for use in other processes.

Ther term "III-V semiconductors" as used herein means those semiconductors commonly called intermetallic or compound, formed of compounds of elements from Group III and Group V of the Periodic Table, such as aluminium phosphide, aluminium arsenide, aluminium antimonide, gallium phosphide, gallium arsenide, gallium antimonide, indium phosphide, indium arsenide and indium antimonide.

CLAIMS:

1.    A process for the production of polyphosphide crystals characterised in that it comprises liquid phase growth of polyphosphide crystals from a polyphosphide melt.

2.    A process as claimed in claim 1 comprising:
       (A) heating a polyphosphide charge to a melt having a temperature substantially within the range of from 650 to 670°C; and
       (B) slowly cooling the melt to form polyphosphide crystals.

3.    A process as claimed in claim 2 comprising:
       (C) bringing the melt into contact with a substrate to form crystals on the substrate during the slow cooling step.

4.    A process as claimed in claim 3 comprising:
       (D) removing the melt from the substrate at the termination of the slow cooling step.

5.    A process as claimed in claim 4 comprising:
       (E) terminating the slow cooling step when the melt reaches a temperature substantially in the range of from 630 to 640°C.

6.    A process as claimed in any of claims 2 to 5 wherein the charge is contained in a sealed ampule before the heating step.

7.    A process as claimed in claim 6 wherein the ampule is evacuated prior to the heating step.

8.    A process as claimed in claim 6 or claim 7 wherein the sealed ampule is tilted after the heating step to bring the melt into contact with a substrate.

9.    A process as claimed in any of claims 2 to 8 wherein the slow cooling step is carried out at a rate substantially within the range of from 6 to 60C° per hour.

10.   A process as claimed in any of claims 3 to 9 wherein the substrate is quartz, nickel or a III-V semiconductor.

11.   A process as claimed in claim 10 wherein the semiconductor is gallium arsenide or gallium phosphide.

12.   A process as claimed in any of claims 1 to 11 wherein the polyphosphide is $KP_{15}$.

13.   A process as claimed in any of claims 1 to 12 wherein the melt comprises a metal dopant.

14.   A process as claimed in claim 13 wherein the dopant is nickel.

1 / 1

FIG. 1

0132954

FIG. 2

FIG. 3